# EUROPÄISCHE PATENTSCHRIFT

(11) **EP 0 839 928 B1**
(45) Veröffentlichungstag und Bekanntmachung des Hinweises auf die Patenterteilung: **15.01.2003**
(21) Anmeldenummer: 97115054.5
(22) Anmeldetag: 30.08.1997
(51) Int. Cl.: C23C 16/44, C23C 16/50, C23C 16/54

(54) **Remote-Plasma-CVD-Verfahren**
Remote plasma CVD method
Procédé de CVD assisté par plasma éloigné

(30) Priorität: 30.10.1996 DE 19643865
(43) Veröffentlichungstag der Anmeldung: 06.05.1998
(73) Patentinhaber: Schott Glas, 55122 Mainz (DE); CARL-ZEISS-STIFTUNG trading as SCHOTT GLASWERKE, 55122 Mainz (DE)
(72) Erfinder: Paquet, Volker, 55126 Mainz (DE)

(56) Entgegenhaltungen:
- EP-A- 0 503 082
- WO-A-98/08998
- DE-A- 4 211 746
- US-A- 5 560 779
- PATENT ABSTRACTS OF JAPAN vol. 013, no. 069 (C-569), 16.Februar 1989 & JP 63 262466 A (HITACHI LTD), 28.Oktober 1988,
- PATENT ABSTRACTS OF JAPAN vol. 015, no. 450 (C-0885), 15.November 1991 & JP 03 191068 A (MATSUSHITA ELECTRIC IND CO LTD), 21.August 1991,
- PATENT ABSTRACTS OF JAPAN vol. 013, no. 414 (C-635), 13.September 1989 & JP 01 149965 A (HITACHI LTD), 13.Juni 1989,
- PATENT ABSTRACTS OF JAPAN vol. 009, no. 188 (C-295), 3.August 1985 & JP 60 054996 A (KAGAKUGIJUTSUCHO MUKI ZAISHITSU KENKYUSHO;OTHERS: 0J), 29.März 1985,

## Beschreibung

Die Erfindung betrifft ein Remote-Plasma-CVD-Verfahren zum Beschichten oder zum Behandeln großflächiger Substrate, bei welchem die Anregung des Beschichtungsgases über ein entfernt von der zu beschichtenden Substratoberfläche mittels eines Plasmas angeregtes Anregungsgas erfolgt und das Anregungsgas in mehreren über dem Substrat angeordneten Plasmaquellen angeregt und von dort aus dem Substrat mit dem Reaktionsgas zgeführt wird. Des weiteren betrifft die Erfindung eine Vorrichtung zur Durchführung des Verfahrens.

Zur Behandlung von Oberflächen von Substraten werden oft Plasmen verwendet, die durch Einwirkung von elektrischer Energie mit unterschiedlicher Frequenz - von Null (Gleichspannung) bis Mikrowellenfrequenz - angeregt werden. Die elektromagnetische Einwirkung kann derart erfolgen, daß das Plasma eines Reaktionsgases in direktem Kontakt mit dem zu behandelnden Substrat erzeugt wird, wodurch das Reaktionsgas in reaktive Spezies zerlegt wird, die auf die Substratoberfläche einwirken, oder aber in einem Anregungsgas entfernt von der Substratoberfläche, wobei die Anregung des Reaktionsgases über dieses Anregungsgas erfolgt. Im letzteren Fall handelt es sich um ein sogenanntes Remote-Plasma (andere Bezeichnungen sind Down-Stream-Plasma und Afterglow-Plasma).

Remote-Plasma-CVD-Verfahren sind bekannt und in der Literatur vielfach beschrieben. Bei einem Remote-Plasma-CVD-Verfahren zur Beschichtung von Substraten durchläuft ein aus einem nicht-schichtbildenden Gas oder einer Mischung von mehreren nicht-schichtbildenden Gasen bestehendes Anregungsgas ("Gassorte A"), eine Entladungszone, in der vor allem angeregte und atomare Spezies gebildet werden. Unter nicht-schichtbildenden Gasen werden z. B. Edelgas O₂, H₂, N₂O verstanden. Im sich daran anschließenden entladungsfreien Bereich (Afterglow) wird dieses Anregungsgas, entfernt (remote) von der Anregungsquelle, mit einem aus einem schichtbildenden Gas oder einer Mischung von mehreren Gasen, von denen mindestens eines ein schichtbildendes Gas ist, bestehenden Schichtbildnergas ("Gassorte B"), gemischt. Unter schichtbildenden Gasen werden sog. Precursorgase, z. B. TiCl₄ oder SiH₄, verstanden.

Das Anregungsgas bildet zusammen mit dem Schichtbildnergas das Beschichtungsgas. Das Schichtbildnergas kann, getrennt vom Anregungsgas, ebenfalls eine Anregungszone durchlaufen; Zusammensetzung und Anregungsfeldstärke müssen in diesem Fall so beschaffen sein, daß es nicht vorreagiert oder beschichtet.

Im Durchmischungsbereich findet eine Wechselwirkung zwischen Anregungsgas und Schichtbildnergas statt, die im wesentlichen in der Übertragung von Anregungsenergie von Molekülen oder Atomen der Gassorte A auf Moleküle oder Atome der Gassorte B besteht und die eine homogene Vorreaktion bewirkt. Die vorreagierten Teilchen reagieren dann heterogen mit dem Substrat und bilden dort die Beschichtung.

Die Vorteile eines Remote- gegenüber einem herkömmlichen Plasma-CVD-Verfahrens, bei dem das Plasma in direktem Kontakt mit der zu beschichtenden Substratoberfläche steht, sind:
- Das Substrat erleidet beim Remote-Plasma-CVD-Verfahren keine Strahlungsschädigung, da es nicht hochenergetischen Teilchen aus dem Plasma ausgesetzt ist.
- Aus dem gleichen Grund heizt sich das Substrat höchstens unwesentlich auf.
- Die Herstellung leitfähiger Schichten ist auch im Falle einer Mikrowellenanregung unproblematisch, da im Gegensatz zu anderen Nicht-Remote-Vorrichtungen Mikrowellenfenster so weit vom Beschichtungsbereich entfernt sind, daß sie nicht leitfähig mitbeschichtet werden und somit den weiteren Durchtritt von Mikrowellenstrahlung nicht sperren.
- Die Beschichtung leitfähiger Substrate bereitet keine Schwierigkeiten, da Felder einer plasmaanregenden Strahlung durch sie nicht beeinflußt werden.
- Bei Anregung mittels Mikrowellen wird eine in der Entladungszone möglicherweise vorhandene Mikrowellen-Feldverteilung infolge von ausgleichenden Diffusionsvorgängen des Anregungsgases auf dem Weg zwischen Anregungsort und Substrat praktisch nicht auf der Schicht abgebildet.

Analoges gilt allgemein für die Behandlung von Substratoberflächen, wobei unter Behandlung, das Ätzen oder die Eigenschaftsveränderung von Oberflächen (z. B. Benetzbarkeit) verstanden werden soll.

Im allgemeinen soll die Beschichung oder Behandlung von Substratoberflächen möglichst gleichmäßig sein. Häufig erfolgt die Plasmaerzeugung durch Mikrowellenanregung. In diesem Fall treten bei der gleichmäßigen Beschichtung oder Behandlung von Substratoberflächen Schwierigkeiten auf, wenn die Abmessungen der Substratoberflächen in der Größenordnung der verwendeten Wellenlänge oder darüber liegen.

In der DE 39 23 188 C2 wird ein Remote-Plasma-CVD-Verfahren zur Herstellung von dünnen Schichten auf großflächigen Substraten beschrieben. Die DE 39 23 188 C2 zeigt, wie durch strömungstechnische Maßnahmen dafür gesorgt wird, daß ein Anregungsgas und ein Schichtbildnergas auf einer Strecke, die sich über die Breite der Reaktionskammer erstreckt, gleichmäßig verteilt, laminar über das Substrat geleitet werden. Das Anregungsgas wird auf gleicher Strecke durch eine aus dem Fenster eines länglichen Resonators, dessen Breite der des ihn versorgenden trichterförmig aufgeweiteten Rechteckhohlleiters entspricht, austretende Mikrowellenstrahlung in den Plasmazustand überführt und vermischt sich mit dem Schichtbildnergas in der Reaktionskammer.

Bei dieser Vorrichtung treten folgende Probleme auf: Die in den Resonator eingespeiste Mikrowelle ist interferenzfähig und regt das Anregungsgas über die Auslaßbreite periodisch unterschiedlich stark an. Diese Periodizität spiegelt sich in Unterschieden in den Eigenschaften der abgeschiedenen Schicht, die vom Anregungsgrad abhängen, wider. Der Reaktor ist starr aufgebaut; Beschichtungseigenschaften lassen sich durch Geometrieparamter des Reaktors nicht beeinflussen. Weiterhin ist der Rechteckhohlleiter nur auf eine beschränkte Breite aufweitbar, so daß es nicht möglich ist, Substrate mit größerer zu beschichtender Oberfläche in diesem Reaktor zu beschichten.

In der GB-PS 222 60 49 wird eine Remote-Plasma-CVD-Vorrichtung zur Herstellung von dünnen Schichten auf ruhendem Substrat beschrieben. Das Abgas der Reaktion wird durch Gasausgänge unter dem Substrat abgezogen. Substrate lassen sich dadurch beschichten, daß man das in einem Mikrowellenhohlleiter gebildete Plasma des Anregungsgases durch eine komplizierte Duschenanordnung in Richtung des Schichtbildnergases strömen läßt, das ebenfalls aus einer aus durchlöcherten Rohren bestehenden Gasdusche in Richtung auf das Substrat strömt. Um trotz unterschiedlicher Druckverhältnisse in den Rohren eine über die gesamte Substratoberfläche gleichmäßige (Schichtbildner-)Gasverteilung zu erhalten, müssen die Ausströmlöcher entsprechend unterschiedliche Durchmesser aufweisen. Die derart einmal eingestellte Gleichmäßigkeit der Beschichtung wird dabei nur mit einem festen Prozeßparametersatz, der die Größe des Beschichtungsbereiches, Gasmassenfluß, Gasart, Prozeßdruck und Gasdruck enthält, erreicht. Eine andere Parameterwahl oder eine andere Substratgröße erfordern umfangreiche Vorversuche zur erneuten Erreichung einer uniformen Gasverteilung. Entsprechend ist es nicht möglich, die Gasdusche des Anregungsgases unbegrenzt zu vergrößern, um dadurch in der Größe des Beschichtungsbereiches frei zu sein, da ab einer gewissen Größe der Gasdusche in ihren Randbereichen der Anregungsgrad des Gases zu stark abnimmt.

Die DE 39 26 023 C2 beschreibt eine lineare Remote-Plasmaquelle, bei der das Plasma für das Anregungsgas in einem Mikrowellenleiter erzeugt wird. Das Anregungsgas fließt durch ein Glasrohr und bildet im Plasmazustand in einem koaxialen Mikrowellenleiter den Innenleiter. Durch einen Längsschlitz im Glasrohr kann Anregungsgas austreten, seitlich anströmendes Schichtbildnergas anregen und so eine Beschichtung bewirken. Da sowohl Leistungsabfall der Mikrowelle und Verlust an Anregungsgas in der z-Achse des Anregungsrohres auftritt, wird die Beschichtung zwangsläufig in dieser Koordinate ungleichmäßig. Ein weiterer Nachteil dieser Vorrichtung liegt in ihrer beschränkten Länge.

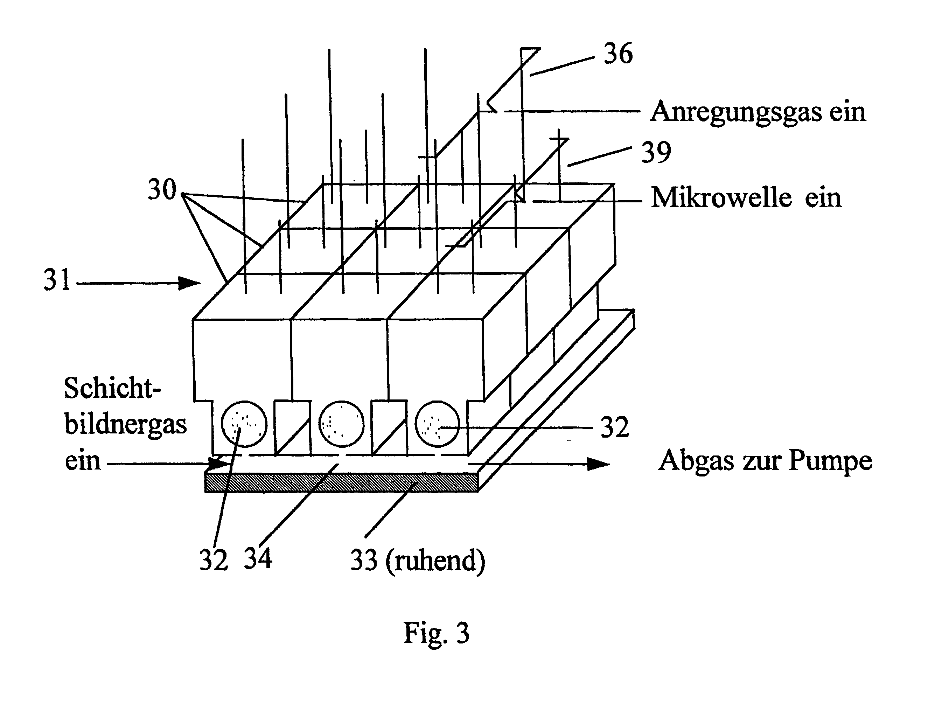

Figur 3 dieser Patentschrift zeigt eine Ausführungsform mit zwei parallel betreibbaren Mikrowellenanordnungen, die hintereinander angeordnet sind. Hierbei handelt es um eine Photo-CVD-Anregung. Auch diese Anordnung besitzt die oben beschriebenen Nachteile der Einzelquelle.

Die DE 38 30 249 C2 beschreibt ein Verfahren zum Beschichten großflächiger Substrate mittels eines "direkten". Plasmas, wobei mittels mehrerer, über der Substratoberfläche in einem Raster angeordneter Plasmaelektroden, deren Plasmasäulen einander überlappen, eine großflächige Plasmazone erzeugt wird, wobei die Plasmaanregung vorzugsweise durch Mikrowellen erfolgt. Obwohl mit diesem Verfahren bereits sehr gute Ergebnisse erzielt werden, lassen sich Randeffekte im Bereich der überlappenden Plasmasäulen nicht völlig ausschließen.

Aus der JP 63262466 A ist ein Plasma-CVD-Beschichtungsverfahren bekannt, bei welchem zur Herstellung eines elektrooptisch sensitiven Körpers mehrere Plasmaquellen um ein zu beschichtendes zylinderförmiges Substrat herum angeordnet sind. In die Plasmaquellen wird ein Beschichtungsgas eingeleitet, welches mittels Mikrowelleneinstrahlung angeregt wird. Um die Plasmaquellen herum angeordnete Magnete beschleunigen die Ionen aus dem Plasma in Richtung auf die Beschichtungskammer hin, wo sie dann mit einem weiteren, direkt in die Kammer eingeleiteten Beschichtungsgas reagieren. Die Reaktionsprodukte werden auf dem Substrat abgeschieden und bilden dort eine Beschichtung.
Um eine möglichst gleichmäßige Beschichtung zu gewährleisten, wird das Substrat während des Beschichtungsprozesses um seine Zylinderachse in eine Rotationsbewegung versetzt und zusätzlich noch entlang der Achse hin- und herbewegt. Nachteilig an dieser Anordnung ist, daß die Vorrichtung wie auch das Verfahren nicht an andere Substratgeometrien anpaßbar sind.

Aus WO 98/08998 ist eine Plasma-CVD-Anlage mit einem Array von Mikrowellen-Plasmaelektroden und einer Steuerschaltung bekannt, wobei je zwei benachbarte Plasmaelektroden durch die Steuerschaltung zu verschiedenen Zeiten mit Mikrowellenimpulsen beaufschlagt werden, und die Dauer der einzelnen Mikrowellenimpulse kurz ist gegenüber der Dauer eines Impulses des bekannten Plasma-Impuls-CVD-Verfahrens.

Aufgabe der Erfindung ist ein Verfahren und eine Vorrichtung zum Beschichten bzw. Behandeln von Substraten mittels eines Plasmas bereitzustellen, welche es gestatten, auch großflächige Substrate mit einer gleichmäßigen Beschichtung zu belegen bzw. deren Oberfläche gleichmäßig zu behandeln, und bei welchen die Anpassung an unterschiedliche Substratgeometrien in einfacher Weise möglich ist.

Die Aufgabe wird hinsichtlich des Verfahrens gelöst mit einem Verfahren mit allen Merkmalen des Anspruchs 1. Eine Vorrichtung zur Durchführung des erfindungsgemäßen Verfahrens ist in Anspruch 10 beschrieben.

Gemäß der Erfindung werden die Plasmaquellen als Module ausgebildet und der Beschichtungsbereich durch einfaches Aneinanderfügen gleichartiger Module an die Größe und Gestalt der Substratoberfläche angepaßt. Hierbei werden die Plasmaquellen entweder in einem Raster oder in einer Reihe über der Substratoberfläche angeordnet.

Als Plasmaquelle wird im Sinne dieser Erfindung eine Vorrichtung verstanden, innerhalb welcher das Anregungsgas entfernt von der zu beschichtenden Substratoberfläche mittels eines Plasmas in einen angeregten Zustand versetzt wird.

Eine Plasmaquelle kann einen sehr einfachen Aufbau aufweisen. Im einfachsten Fall besitzt sie eine Anregungskammer, in der das Plasma im Anregungsgas erzeugt wird, Mittel zum Zuführen des Anregungsgases und zum Einleiten der Energie zur Erzeugung des Plasmas sowie Einrichtungen, die den Austritt des angeregten Gases in Richtung auf das Substrat hin, erlauben. Die Plasmaquelle kann darüber hinaus z. B. auch noch Einrichtungen zum Zu- und/oder Abführen des Reaktionsgases bzw. verbrauchten Gase sowie zur Anregung des Reaktionsgases aufweisen. Als Reaktionsgas soll in diesem Zusammenhang das Gas bzw. die Gasmischung verstanden werden, die auf die Substratoberfläche einwirkt, z. B. das Schichtbildnergas. Im folgenden soll die Erfindung ohne Beschränkung der Allgemeinheit am Beispiel des Beschichtens erläutert werden.

Die erfindungsgemäße Ausbildung der Plasmaquellen als Module (im folgenden werden die einzelnen Plasmaquellen auch Module genannt) hat den Vorteil, daß
- der Beschichtungsbereich durch einfaches Aneinanderfügen gleichartiger Module an die Gestalt und Größe der Substratoberfläche angepaßt werden kann, und
- im Falle eines Mikrowellen-Remote-Plasma-CVD-Verfahrens die Anregung innerhalb eines Mirkowellenbauteils und deshalb besonders stark erfolgt, so daß vom Grad der Ariregung abhängige Eigenschaften der entstehenden Schicht beeinflußt werden können.

In einer Ausführungsform der Erfindung wird das Schichtbildnergas in einer laminaren Strömung parallel zur Substratoberfläche über die gesamte Breite der Vorrichtung so in Richtung des aus den Modulen ausfließenden Anregungsgases geführt, daß es sich mit diesem vermischt. Das Schichtbildnergas kann aber auch individuell über die einzelnen Module oder über Modulgruppen zugeführt werden. Diese Variante hat den Vorteil, daß eine auf der gesamten Beschichtungsbreite gleichmäßige Laminarströmung nicht installiert werden muß, jedoch den Nachteil, daß zusätzlicher Aufwand für die Verteilung des Gases auf die Module oder Modulgruppen erforderlich ist.

Es ist auch möglich, das Schichtbildnergas vor der Vermischung mit dem Anregungsgas durch eine zusätzliche Energiequelle ebenfalls anzuregen. Dies ist dann erlaubt, wenn dabei das Schichtbildnergas sich nicht unter Schichtbildung zersetzt. Ein Vorteil dieser Maßnahme besteht darin, daß die entstehende Mischung beider (angeregter) Gassorten besonders reaktionsfreudig ist. Steht nur eine einzige Energiequelle für die Anregung von Schichtbildner- und Anregungsgas zur Verfügung, dann kann beispielsweise das Schichtbildergas im Modul zusammen mit dem Anregungsgas, aber in einer isolierten Gasleitung, geführt und in Substratnähe mit dem Schichtbildnergas gemischt werden. Falls das Schichtbildnergas leichter in den Plasmazustand überführbar ist als die Anregungsgas, würde die in das Modul gespeiste elektrische Leistung vorwiegend vom Plasma des Schichtbildnergases absorbiert und stünde für eine Anregung des Anregungsgases nicht mehr im erforderlichen Ausmaß zur Verfügung. Es ist deshalb vorteilhaft, dann die zusätzliche Anregung nur in einem Bereich des Moduls stattfinden zu lassen, in dem die elektrische Feldstärke von ihrem Maximalwert im Energieraum je nach Unterschied der Anregungsenergien beider Gase mehr oder weniger abgefallen ist. Ist das Schichtbildnergas schwerer anzuregen als das Anregungsgas, kann es günstig sein, die Rolle beider Gassorten bezüglich der Anregung zu vertauschen.

In einer weiteren Ausführungsform der Erfindung wird das Schichtbildnergas über eine Gasdusche, oberhalb derer sich die modular aufgebauten Plasmaquellen für das Anregungsgas befinden, zugeführt. Die Austrittsöffnungen für das Schichtbildnergas liegen auf der dem Substrat zugewandten Seite der Gasdusche; die Gasdusche selbst ist so geformt, daß von ihrer substratabgewandten Seite in Richtung auf das Substrat strömendes Anregungsgas an ihr vorbei- oder durch sie hindurchtreten kann. Mögliche Duschenformen sind ein gerade, spiralig oder mäanderförmig gebogenes Rohr. Länge und Flächengröße der Gasdusche entsprechen der Länge der linearen Quelle bzw. der Fläche der fächenhaften Quelle.

Sind die Module nur in einer Reihe angeordnet, dann wird die Quelle im folgenden "lineare Remote-Plasmaquelle" genannt. Bei einer solchen Anordnung wird während der Beschichtung das Substrat unter dieser Quelle bewegt oder diese Quelle über das Substrat geführt, so daß das gesamte Substrat von der Quelle überstrichen wird, um so eine gleichmäßige Beschichtung zu gewährleisten.

Sind die Module über der Substratoberfläche in einem Raster angeordnet, dann wird die Quelle im folgenden "flächenhafte Remote-Plasmaquelle" genannt. Bei einer solchen Anordnung ist eine Relativbewegung zwischen Quelle und Substrat nur dann erforderlich, wenn die Fläche des Substrats größer ist als die der Remote-Plasmaquelle bzw., wenn, wie nachfolgend beschrieben wird, eine besonders gleichmäßige Beschichtung erzielt werden soll.

Nachfolgend wird die Erfindung anhand der Figuren näher erläutert:

Es zeigen:
- Figur 1:: in perspektivischer Darstellung eine modulartig aufgebaute lineare Remote-Plasmaquelle gemäß der Erfindung,
- Figur 2:: in perspektivischer Darstellung eine weitere erfindungsgemäße lineare Remote-Plasmaquelle, bei welcher auch das Schichtbildnergas über die einzelnen Module zugeführt wird,
- Figur 3:: in perspektivischer Darstellung eine erfindungsgemäße flächenhafte Remote-Plasmaquelle,
- Figur 4:: in perspektivischer Darstellung eine weitere erfindungsgemäße flächenhafte Remote-Plasmaquelle, bei welcher die Gaszu- und-abfuhr jeweils über die einzelnen Module erfolgt,
- Figuren 5a + b:: koaxiale Module,
- Figur 6:: Hohlleiter-Module,
- Figur 7a:: eine aus Hohlraumresonatoren zusammengesetzte lineare Remote-Plasmaquelle,
- Figur 7b:: in Draufsicht eine aus Hohlraumresonatoren zusammengesetzte flächenhafte Remote-Plasmaquelle,
- Figuren 8a - c:: die Abhängigkeit des Verlaufs der Schichteigenschaften von dem Winkel zwischen Bewegungsrichtung des Substrats und der Achse einer linearen Remote Plasmaquelle.

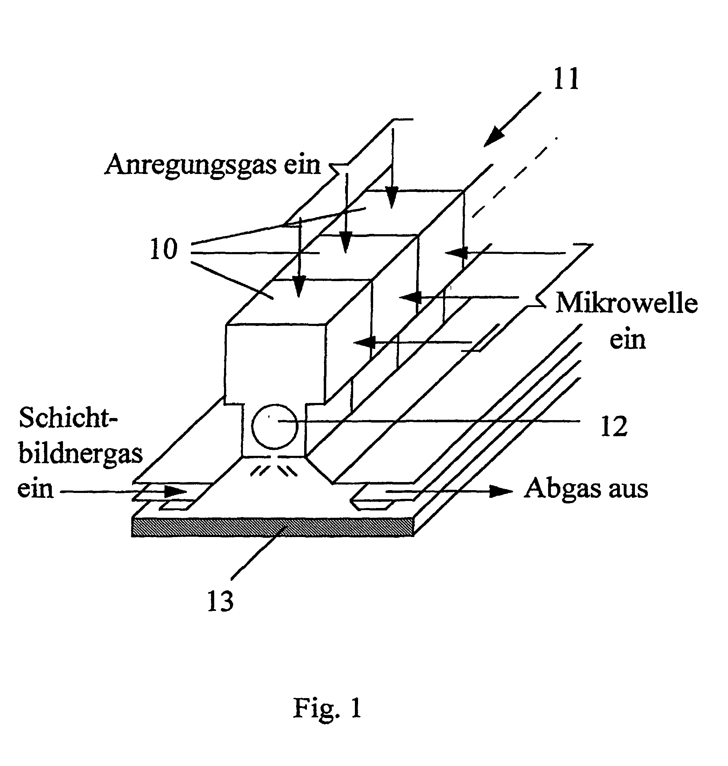

Die Figuren 1 bis 7b zeigen Vorrichtungen, die zur Durchführung des erfindungsgemäßen Verfahrens besonders geeignet sind.

In Figur 1 ist eine Vorrichtung dargestellt, die zur Beschichtung eines bewegten Substrats geeignet ist. Mehrere nebeneinander angeordnete Module (10) bilden eine lineare Remote-Plasmaquelle (11), wobei die Anregung bei dem dargestellten Ausführungsbeispiel vorteilhafterweise mittels Mikrowellen erfolgt.

Vorteile der Plasmaerzeugung durch Mikrowellen gegenüber niederfrequenteren Anregungen, liegen darin, daß
- keine Elektroden benötigt werden,
- das Plasma wegen der vergleichsweise hohen Elektronendichte auch bei höheren Drücken als bei niederfrequenteren Anregungen aufrechterhalten werden kann und
- Beschichtungs- oder Ätzraten besonders hoch sind.

Ein Modul (10) kann im Falle der Mikrowellenanregung durch einen Mikrowellenhohlleiter, einen Mikrowellenresonator, ein das Gas führendes dielektrisches Rohr in einem Mikrowellenleiter oder in einem Mikrowellenresonator oder einen koaxialen Mikrowellenleiter, dessen Innenleiter das Plasma des anzuregenden Gases ist, gebildet werden. In dem dargestellten Ausführungsbeispiel wird das Anregungsgas von oben in jedes Modul (10) eingeleitet, die Zuführung der Mikrowellenenergie erfolgt ohne Beschränkung der Allgemeinheit von der Seite her. Am unteren Ende des Moduls (10) wird in dem Anregungsgas ein Plasma (12) gezündet. Das angeregte Anregungsgas tritt schließlich unten aus dem Modul (10) in Richtung auf die Substratoberfläche (13) aus.

Jedes Modul (10) wird in dem gezeigten Ausführungsbeispiel vorteilhafterweise individuell mit Mikrowellenenergie versorgt. Die Versorgung kann entweder über einen jedem Modul zugeordneten Mikrowellenerzeuger (Magnetron) erfolgen oder durch Mikrowellenauskopplung in jedes Modul aus einem allen Modulen gemeinsamen, von einem oder zwei Magnetrons gespeisten Mikrowellenleiter. Die Auskopplung kann nach bekannten Techniken, z. B. über Stab-, Loch- oder Schlitzantennen, erfolgen. Dabei wird der Kopplungsgrad für jedes Modul so (z. B. über die Eintauchtiefe der Koppelantenne) eingestellt, daß die in Mikrowellenausbreitungsrichtung abnehmende Mikrowellenleistung durch eine größere Kopplung ausgeglichen wird. Dadurch, daß die einzelnen Module unabhängig voneinander schalt- und steuerbar sind, können Inhomogenitäten in den Schichteigenschaften zusätzlich über die in jedes Modul individuell eingespeiste Mikrowellenleistung ausgeglichen werden. Das Schichtbildnergas strömt bei der in Figur 1 dargestellten Ausführungsform in einer laminaren Strömung über die Substratoberfläche (13) hinweg und vermischt sich mit dem aus den Modulen (10) austretenden Anregungsgas in dem Reaktionsraum (14) zwischen Modulanordnung (11) und Substratoberfläche (13). Die Abgase werden von einer Vakuumpumpe (nicht gezeigt) abgepumpt.

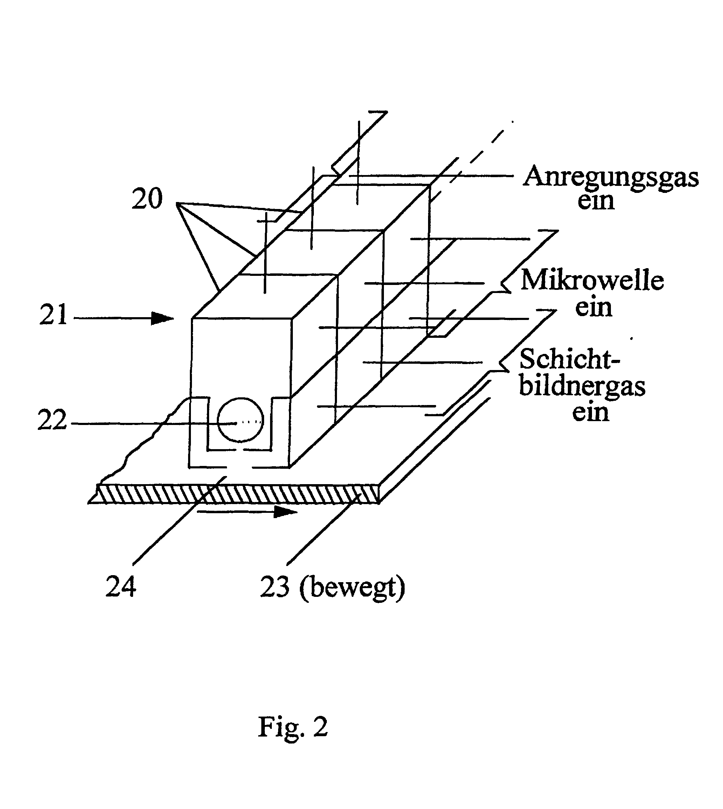

Figur 2 zeigt eine lineare Remote Plasmaquelle (21), bei der das Schichtbildnergas individuell über die einzelnen Module (20) zugeführt und in Substratnähe mit dem Anregungsgas gemischt wird. Das Schichtbildnergas wird in Figur 2 über seitlich an den Modulen (20) angeordnete Gasleitungen zugeleitet.

Mit den Vorrichtungen nach Figur 1 und 2 kann sowohl im Plasma-CW(contineous wave)-Betrieb als auch im Plasma-Impuls-CVD-Verfahren (PICVD) bei dem periodisch immer dann ein Plasma für die Dauer, die für den Schichtbildungsvorgang benötigt wird, gezündet und aufrechterhalten wird, wenn das gesamte Substrat mit frischem Beschichtungsgas beaufschlagt ist und Restgase einer vorangegangenen Abscheidungsreaktion durch Frischgas verdrängt sind, gearbeitet werden. Ein Vorteil des PICVD-Verfahrens liegt beispielsweise darin, mit höheren Leistungen bei niedriger Substrattemperatur arbeiten zu können, was i. a. die Haftfestigkeit und Schichtqualität günstig beeinflußt. Ein Vorteil des CW-Betriebs liegt in einer kostengünstigen Beschichtungsanlage.

Mit (22) ist in Figur 2 das Plasma des Anregungsgases und mit (24) der Reaktionsraum bezeichnet.

Figur 3 zeigt eine flächenhafte Remote-Plasmaquelle (31), bei der das Schichtbildnergas wie in Figur 1 in einer laminaren Strömung über das Substrat (33) geleitet wird und sich mit dem senkrecht zu dieser Strömung aus den Modulen (30) austretenden Anregungsgas vermischt. Mit (32) ist in Figur 2 das Plasma des Anregungsgases und mit (34) der Reaktionsraum bezeichnet, mit (36) die Zuleitung des Anregungsgases.
Würde mit der Quelle aus Figur 3 mit zeitlich konstanter Mikrowellenzufuhr (CW-Betrieb) beschichtet werden, so würde das Schichtbildnergas zu einem hohen Anteil bereits in den ersten angeströmten Modulen verbraucht werden, so daß die nachfolgenden nicht mehr ausreichend mit Schichtbildnergas versorgt werden würden. Eine Beschichtungsanlage, die mit einer Vorrichtung entsprechend Figur 3 arbeitet, erfordert deshalb unbedingt einen Mikrowellengenerator, der die Abgabe von gepulster Mikrowellenleistung gestattet, damit nach dem PICVD-Verfahren beschichtet werden kann.

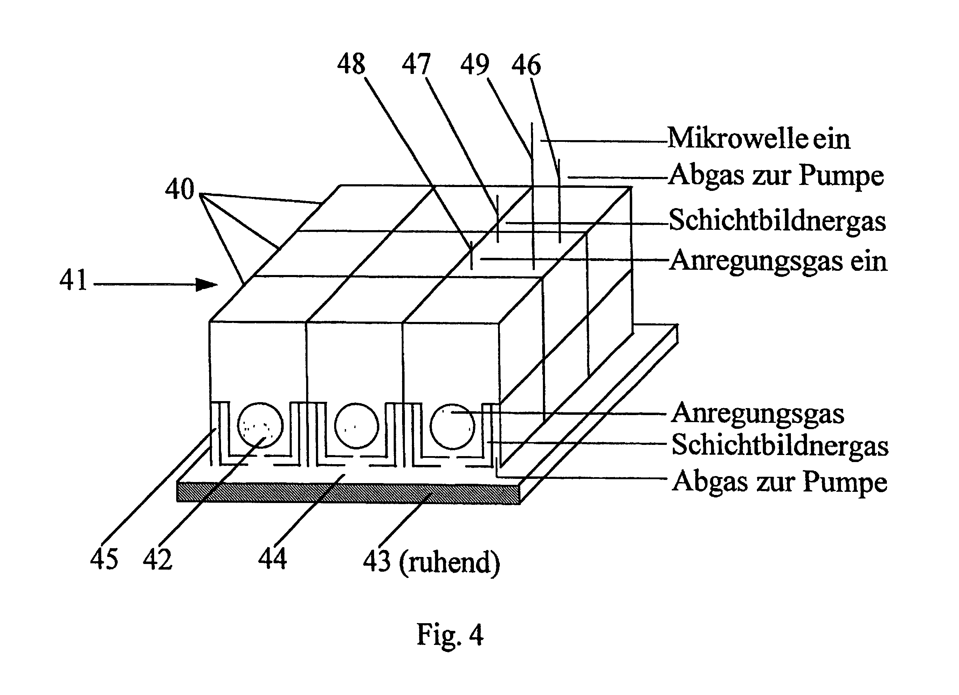

Figur 4 zeigt eine flächenhafte Remote-Plasmaquelle (41), bei der analog zu Figur 3 das Schichtbildnergas individuell über die einzelnen Module (40) zugeführt und in Substratnähe mit dem Anregungsgas gemischt wird.

Bei einer Beschichtung mit flächenhaften Quelle mit einer gemeinsamen Abgasableitung und einer über die Zeit konstanten Mikrowellenzufuhr (CW-Betrieb) würde die für alle Module gleichmäßige Beseitigung des Abgases nicht gewährleistet sein, da das Abgas der innenliegenden Module einen längeren Weg zur Pumpe benötigt als das der außenliegenden. Wegen örtlich unterschiedlicher Prozeßgasmischungen würde die Beschichtungsrate örtlich ungleichmäßig werden. Eine Beschichtungsanlage, die mit einer Vorrichtung entsprechend Figur 4 arbeitet, erfordert deshalb vorzugsweise einen Mikrowellengenerator, der die Abgabe von gepulster Mikrowellenleistung gestattet, damit mittels eines PICVD-Verfahren beschichtet werden kann. In Figur 4 ist das Substrat (43) ruhend angeordnet.

Die Quelle nach Figur 4 weist eine den einzelnen Modulen zugeordnete Absaugvorrichtung (45) auf und kann daher auch im CW-Betrieb betrieben werden. Mit (46) sind in Figur 4 die aus den einzelnen Modulen (40) austretenden Abgasleitungen bezeichnet, die Zuleitungen für das Schichtbildnergas mit (47) die Zuleitungen für das Anregungsgas mit (48), der Reaktionsraum mit (44) und das Plasma des Anregungsgases mit (42).
Bei den in den Figuren 3 und 4 dargestellten Vorrichtungen wird die Mikrowelle über die Zuleitungen (35,49) in die einzelnen Module (30/40) eingekoppelt.

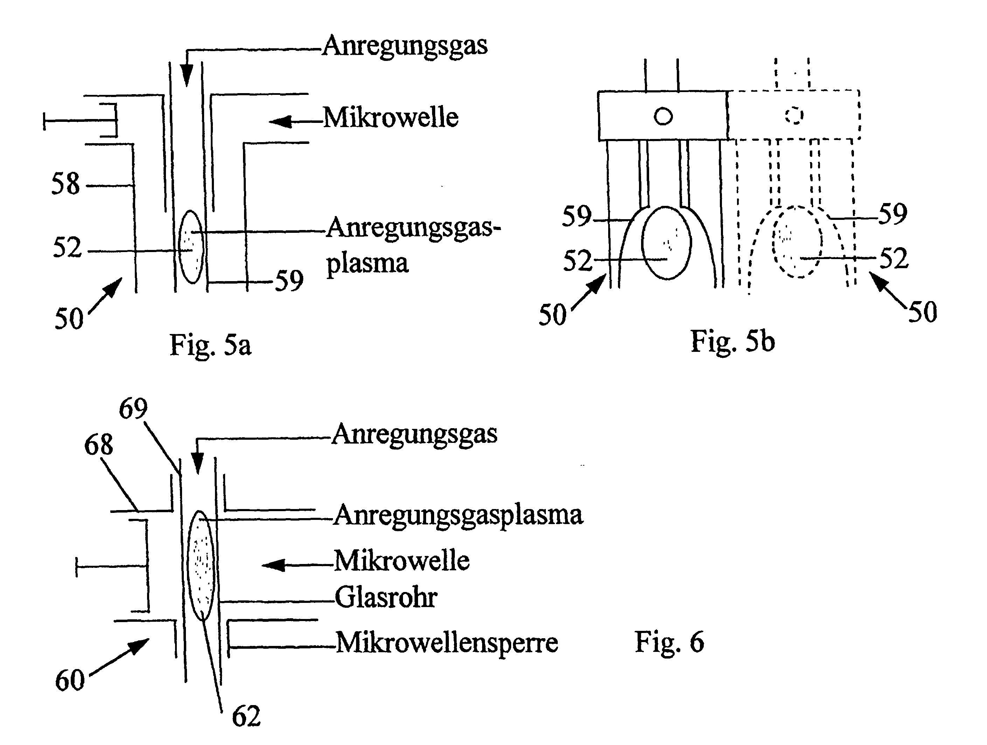

In Figur 5a ist beispielhaft ein Plasmaquellen-Modul (50) dargestellt, das wegen seiner geometrischen Beschaffenheit vorzugsweise für eine lineare Plasmaquelle geeignet ist. Es besteht aus einer koaxialen Mikrowellenleitung in der der Außenleiter durch ein Metallrohr (58) und der Innenleiter durch das in einem dielektrischen Rohr (59) gezündete Anregungsgasplasma (52) gebildet wird. Die Vergleichmäßigung der Verteilung des angeregten Gases auf die Beschichtungsstrecke kann durch Aufweitung der Innenleiterrohres (59) (Figur 5b) oder durch Vergrößerung des Abstandes zum Substrat erfolgen. Über Leistungsparameter des Mikrowellengenerators kann die Lage des Plasmas (52) im Rohr (59) beeinflußt werden. Das Rohr (59) besteht vorzugsweise aus Quarzglas oder einem Mehrkomponentenglas.

Das in Figur 6 gezeigte Modul (60) ist vorzugsweise ebenfalls für eine lineare Plasmaquelle geeignet und besteht aus einem durch einen Rechteckhohlleiter (68) gestecktes dielektrisches Rohr (69), das sich am Ort maximaler E-Feldstärke befindet, so daß in diesem Rohr (69) ein Anregungsgasplasma (62) gezündet werden kann.

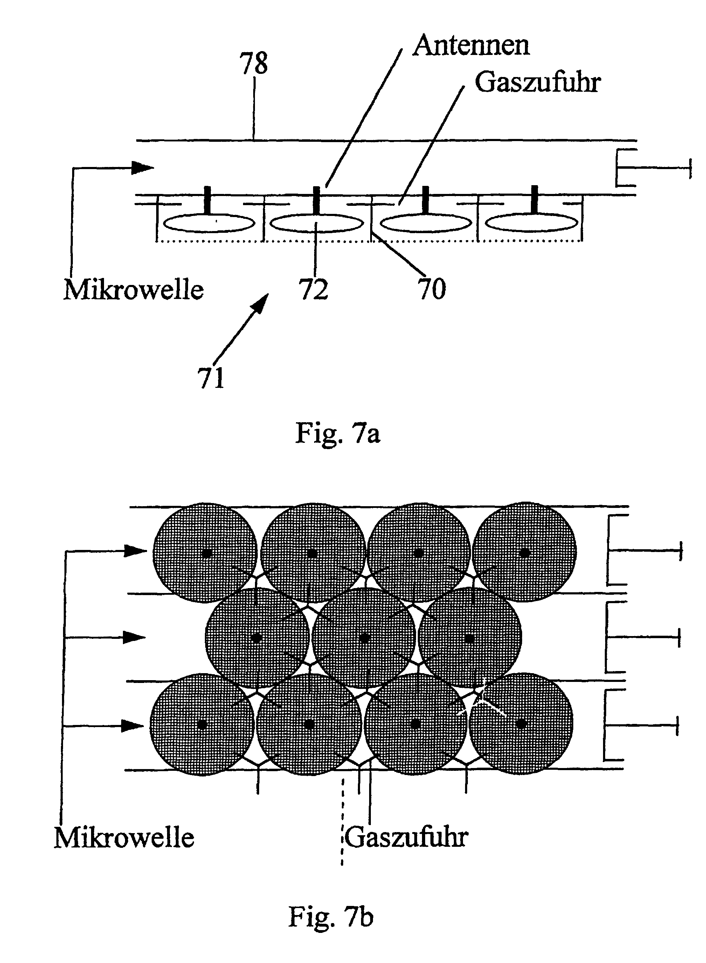

Figur 7a zeigt ein aus einer Reihe von Modulen (70) zusammengesetzte lineare Remote-Plasmaquelle (71). Die Module (70) sind hier Hohlraumresonatoren, die hintereinander mit einem von einem Megnetron gespeisten Rechteckhohlleiter (78) verbunden sind. Aus dem Rechteckhohlleiter (78) werden, z. B. kapazitiv, in jedes Modul (70) Mikrowellen eingekoppelt. Die Einkopplung kann auch über Loch- oder Schlitzantennen erfolgen. Dabei wird der Kopplungsgrad, der den Leistungseintrag in jedes Modul bestimmt, bei kapazitiver Kopplung über die Eintauchtiefe der Koppelantenne, bei Lochkopplung über den Lochdurchmesser und bei Schlitzkopplung über Länge und Breite des Schlitzes vorgegeben. Bei Loch- und Schlitzkopplung wird über ein dielektrisches Mikrowellenfenster dafür gesorgt, daß die in die Hohlraumresonatoren geleitete Gassorte A nicht in den Rechteckhohlleiter fließen kann.

Substratseitig kann eine elektrisch leitfähige Resonatorwand (72) vorgesehen sein, die beispielsweise aus einem metallischen Gitter oder Netz bestehen kann, durch das das Anregungsgas austreten kann.

Figur 7b zeigt eine aus mehreren linearen Remote-Plasmaquellen flächenhafte Plasmaquelle (73).

Bei der oben beschriebenen Anordnung modular aufgebauter Plasmaquellen können in den sog. Stoßstellenbereichen zwischen benachbarten Modulen Randeffekte bei der Beschichtung bzw. Behandlung der Substrate auftreten. In diesen Stoßstellenbereichen sind - verglichen mit Bereichen unter diesen Modulen - i.a. der Anregungsgrad des Anregungsgases und die Strömungseigenschaften von Anregungsund Schichtbildnergas verschieden.

Durchläuft nun ein Substratbereich überwiegend Stoßstellenbereiche, so äußert sich dies in unterschiedlichen Schichteigenschaften.

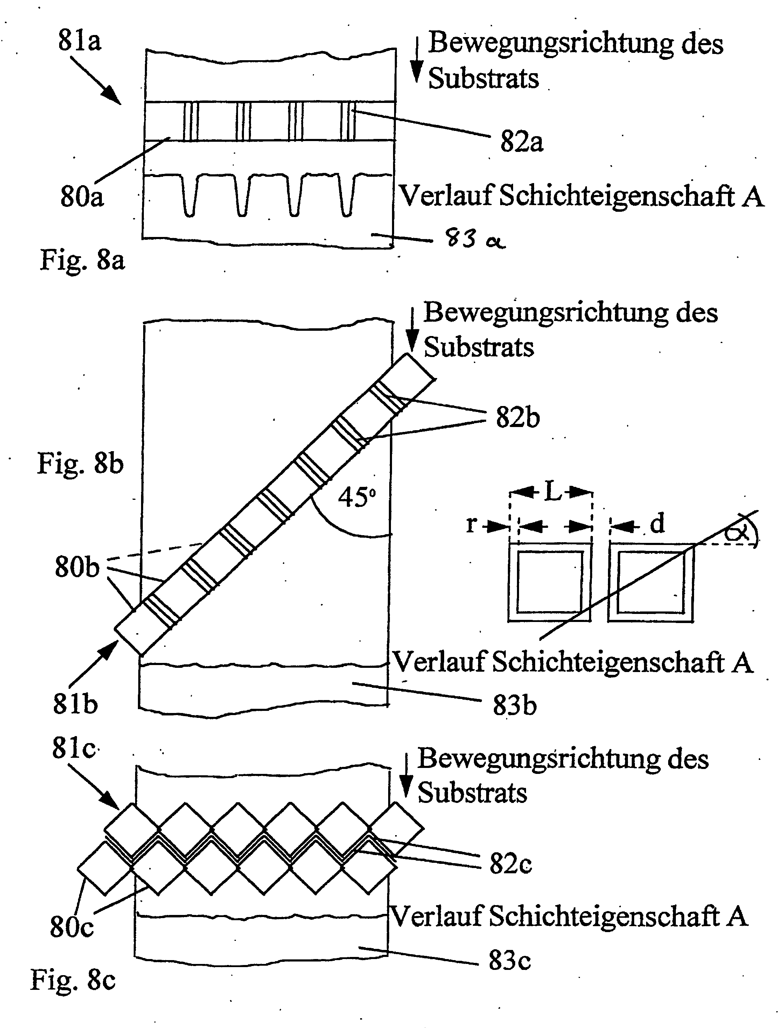

Es liegt auf der Hand, daß solche Randeffekte sehr stark von der Geometrie der Module bzw. der Modulanordnung und insbesondere der Stoßstellenbereiche abhängig sind. Weisen die einzelnen Module auf der dem Substrat zugewandten Seite z. B. eine rechteckige, beispielsweise quadratische Querschnittsfläche auf, so treten die oben beschriebenen Randeffekte besonders deutlich auf, wie in Figur 8a zu erkennen ist. Figur 8a zeigt eine lineare Remote-Plasmaquelle (81a) bestehend aus einer Reihe nebeneinander angeordneter Module (80a) mit quadratischem Querschnitt. Das Substrat ist mit (83a) bezeichnet. Des weiteren ist in Figur 8a der Verlauf einer durch Plasmabehandlung erzeugten Schichteigenschaft A auf dem Substrat bei dieser Modulanordnung dargestellt. Das Substrat wird im gezeigten Ausführungsbeispiel unter der Modulanordnung hindurchgeführt. Man erkennt, daß es Substratbereiche gibt, die ausschließlich unter den Stoßstellenbereichen (82a) der Modulanordnung hindurchlaufen, während die dazwischenliegenden Substratbereiche ausschließlich unter den Modulen (80a) selbst hindurchgeführt werden. In den Stoßstellenbereichen (82a) ist die Wirkung der Plasmabehandlung bzw. -Beschichtung deutlich reduziert. Dies macht sich beim Verlauf der Schichteneigenschaft A in Abhängigkeit von der Modulanordnung jeweils in einem Minimum im entsprechenden Stoßstellenbereich (82a) zwischen zwei benachbarten Modulen (80a) bemerkbar.

Eine einfache Maßnahme zur Minderung solcher Randeffekte besteht darin, das Substrat und die Modulanordnung relativ zueinander so zu bewegen, daß jede Stelle des Substrats Stoßstellenbereich und die übrigen Bereiche eines Moduls gleichermaßen durchläuft. Diese Maßnahme ist nicht nur für ein Remote-Plasma-CVD-, sondern generell für jedes Plasma-CVD-Verfahren mit einer aus mehreren Plasmaelektroden oder -antennen bestehenden Plasmaquellenanordnung geeignet, z. B. auch für die aus der eingangs beschriebenen DE 38 30 249 C2 bekannte Elektrodenanordnung. Die nachfolgenden Ausführungsformen sind daher auch auf diese Technologie anwendbar.

In den Figuren 8b und 8c sind am Beispiel der linearen Remote-Plasmaquelle ohne Beschränkung der Allgemeinheit bevorzugte Ausführungsformen für Modulanordnung mit verminderten Randeffekten dargestellt. Es liegt auf der Hand, daß sich der gewünschte Effekt mit einer Vielzahl von verschiedenen Anordnungen die hier nicht alle aufgezeigt werden können, erreichen läßt. Der Fachmann kann die für ihn geeignetste Anordnung aufgrund der Angaben in diesem Text ohne erfinderisches Zutun leicht auffinden.

Ordnet man beispielsweise die lineare Remote-Plasmaquelle so an, daß ihre Achse zur Bewegungsrichtung des Substrats einen Winkel α kleiner als 90 ° einnimmt, werden die Abweichungen der Schichteigenschaften mit abnehmenden Winkel immer geringer, weil der Bewegungsvektor des Substrates an der Stelle der Stoßstelle zunehmend stoßstellenfreie Bereiche des Moduls erfaßt und so eine ausgleichende Wirkung erzielt wird.
Bei einem Winkel von etwa 45 ° (der genaue Wert läßt sich aus α = arcsin {(L-r)/(L+d+r)} berechnen; L = Länge des Moduls, r = Dicke der Randzone, d. h. des möglicherweise stark inhomogenen Plasmabereiches an der inneren Modulwand, d = 2x Dicke der Modulwand + Abstand zum benachbarten Module, ) durchschneidet der Bewegungsvektor des Substrates an jeder Stelle des Substrates gerade 1 x eine Stoßstelle und etwa gleichlange Strecken im Modul.

Figur 8b zeigt in schematischer Darstellung eine lineare Remote-Plasmaquelle (81b) deren Achse etwa unter 45 ° zur Bewegungsrichtung des Substrates (83b) angeordnet ist und den sich mit dieser Anordnung ergebenden Verlauf einer Schichteigenschaft A. Man erkennt, daß die Kurve A deutlich geglättet ist.

Figur 8c zeigt in schematischer Darstellung eine lineare Remote-Plasmaquelle (81c), deren Achse senkrecht zur Bewegungsrichtung des Substrates (83c) angeordnet ist und bei der durch Schrägstellung der Module (80c) um 45 ° und Hintereinanderanordnung von 2 Modulen dieselbe Wirkung auf die Schichteigenschaft erzielt wird wie nach der Anordnung gemäß Figur 8b.
Diese Anordnung erfordert einerseits weniger Platz, ist aber im Aufbau etwas komplizierter als die Anordnung gemäß Figur 8b. Verkleinert man den Winkel weiter, wird die ausgleichende Wirkung zwar erhöht, infolge des Mehrbedarfs an Modulen ist diese Variante jedoch unwirtschaftlich. Durch eine hohe Zahl untereinander versetzt angeordneter Module bzw. linearer Remote-Plasmaquellen läßt sich - allerdings mit hohem Aufwand - die ausgleichende Wirkung praktisch beliebig steigern. Ordnet man z. B. mehrere, nämlich L/S (/wobei S = d + r) lineare Remote-Plasmaquellen gemäß Figur 8a untereinander so an, daß die jeweils untere um eine Strecke S versetzt ist, lassen sich die Randeffekte ebenfalls vermindern.

Weitere Maßnahmen zur Verminderung von Randeffekten sind folgende:

### Gasdurchlässigkeit der Zwischenwand

Besteht das Modul aus einem metallischen Mikrowellenleiter, z. B. einem Rechteckhohlleiter, der auf einer Seite durch ein gasundurchlässiges Mikrowellenfenster (dielektrische Platte), auf der anderen durch ein mikrowellenundurchlässiges Gasfenster (metallische Lochplatte oder Drahtsieb) abgeschlossen ist, dann wird sowohl eine Verkleinerung der Randzone innerhalb des Moduls und eine Abschwächung der Wirkung der Stoßstelle zwischen zwei Modulen erzielt. wenn die leitenden Trennwände benachbarter Module gasdurchlässig und mikrowellenundurchlässig ausgeführt sind, also beispielsweise mit Löchern versehen sind oder aus einem Drahtgeflecht bestehen, weil eine Vergleichmäßigung der Dichte angeregter Species innerhalb der Module erfolgen kann.

### Abstandsänderung zum Substrat

Für alle Module gilt, daß der Unterschied in den Gaseigenschaften im Bereich der Stoßstellen zu den übrigen Bereichen der Module und damit der unterschied in den betreffenden Schichten um so geringer wird, je größer man den Abstand der Module zum Substrat wählt, wie dadurch die aus den Modulen autretenden Gaströme sich besser durch Diffusion vermischen und so vergleichmäßigen.

Nachteilig kann sich bei dieser Maßnahme, beispielsweise bei einem allen Modulen gemeinsamen Fluß des schichtbildenden Gases, jedoch auswirken, daß die Reichweite des Anregungsgas im schichtbildenden Gas immer geringer wird und davon abhängige Schichteigenschaften (z. B. Rate) abfallen. Diese Möglichkeit muß deshalb vor Anwendung dieser Maßnahme beachtet werden.

### Anhebung der Mikrowellenleistung

Eine weitere Maßnahme betrifft das einzelne Modul. Die Erhöhung der das Plasma anregenden Leistungen bewirkt bei einem Modul, das aus einem metallischen Mikrowellenleiter besteht, z. B. einem Rechteckhohlleiter, der auf einer Seite durch ein gasundurchlässiges Mikrowellenfenster (dielektrische Platte), auf der anderen durch ein mikrowellenundurchlässiges Gasfenster (metallische Lochplatte oder Drahtsieb) abgeschlossen ist, eine Verkleinerung der Randzone und somit eine Vergleichsmäßigung des Plasmas im Modul.

Bei den angegebenen Maßnahmen kann allen Modulen ein gemeinsamer oder jedem Modul ein individueller Fluß des schichtbildenden Gases zugeordnet werden. Soll das schichtbildende Gas zu einem möglichst hohen Anteil in Schichtmaterial umgesetzt werden, empfiehlt es sich, in allen Fällen ein PICVD-Verfahren anzuwenden. Damit wird sichergestellt, daß unter der Fläche der Module vor jedem Beschichtungsimpuls unverbrauchtes schichtbildendes Gas vorhanden ist.

## Patentansprüche

1. Remote-Plasma-CVD-Verfahren zur Beschichtung oder Behandlung großflächiger Substrate,
bei welchem die Anregung des Reaktionsgases über ein entfernt von der zu beschichtenden Substratoberfläche mittels eines Plasmas angeregtes Anregungsgas erfolgt, und
das Anregungsgas in mehreren, über dem Substrat angeordneten Plasmaquellen angeregt und von dort aus dem Substrat mit dem Reaktionsgas zugeführt wird.
**dadurch gekennzeichnet,**
**daß** die Plasmaquellen als Module ausgebildet sind und der Beschichtungsbereich durch Aneinanderfügen gleichartiger Module in einem Raster bzw. einer Reihe an die Größe und Gestalt der Substratoberfläche angepaßt wird und daß das Substrat und die Plasmaquellenanordnung relativ zueinander so bewegt werden, daß der Winkel zwischen der Bewegungsrichtung und der Achse der Plasmaquellenanordnung α < 90° beträgt.

2. Verfahren nach Anspruch 1,
**dadurch gekennzeichnet,**
**daß** das Substrat während der Beschichtung oder Behandlung relativ zur Plasmaquellenanordnung bewegt wird.

3. Verfahren nach Anspruch 2,
**dadurch gekennzeichnet,**
**daß** das Substrat und die Plasmaquellenanordnung zur Verminderung von Randeffekten relativ zueinander so bewegt werden, daß jede Stelle des Substrats Stoßstellenbereiche zwischen benachbarten Modulen und Modulbereichen gleichermaßen durchläuft.

4. Verfahren nach Anspruch 3,
**dadurch gekennzeichnet,**
**daß** α = 45°.

5. Verfahren nach wenigstens einem der Ansprüche 1 bis 4,
**dadurch gekennzeichnet,**
**daß** das Substrat unter der Plasmaquellenanordnung hindurch geführt wird.

6. Verfahren nach wenigstens einem der Ansprüche 1 bis 5,
**dadurch gekennzeichnet,**
**daß** das Plasma mittels Mikrowellen angeregt wird.

7. Verfahren nach Anspruch 6,
**dadurch gekennzeichnet,**
**daß** die in jedes Modul eingeleitete Mikrowellenenergie so groß gewählt wird, daß die durch Stoßstellen zwischen benachbarten Modulen verursachten Randeffekte minimiert werden.

8. Verfahren nach wenigstens einem der Ansprüche 1 bis 7,
**dadurch gekennzeichnet,**
**daß** ein gepulstes Remote-Plasma-CVD-Verfahren (Remote-PICVD-Verfahren) verwendet wird.

9. Plasmaunterstütztes chemisches Abscheidungsverfahren (CVD) zur Beschichtung oder Behandlung großflächiger Substrate,
bei welchem gegenüber von der zu beschichtenden Substratoberfläche mehrere in einem Raster angeordnete, unabhängig voneinander schalt- und steurerbare Plasmaelektroden angeordnet sind, die über der zu beschichtenden Substratoberfläche und in direktem Kontakt mit dieser eine großflächige Plasmazone erzeugen,
**dadurch gekennzeichnet,**
**daß** das Substrat und die Plasmaelektrodenanordnung zur Verminderung von Randeffekten so relativ zueinander bewegt werden, daß jede Stelle des Substrats die durch die Plasmaelektroden jeweils erzeugten Plasma-Säulenbereiche und Überlappungsbereiche dieser Plasmasäulen gleichermaßen durchläuft.

10. Vorrichtung zur Beschichtung oder Behandlung großflächiger Substrate mittels eines Remote-Plasma-CVD-Verfahrens, mit
einem Reaktionsraum mit dem zu beschichtenden Substrat,
Einrichtungen zum Zuführen eines Reaktionsgases in den Reaktionsraum, mehreren Einrichtungen zur Erzeugung eines angeregten Anregungsgases mittels eines Plasmas, welche über der Substratoberfläche angeordnet sind,
Einrichtungen zum Zuführen des angeregten Anregungsgases in den Reaktionsraum mit dem Reaktionsgas und dem zu beschichtenden Substrat sowie Einrichtungen zum Abführen verbrauchter Gase,
**dadurch gekennzeichnet,**
**daß** die Einrichtungen zum Erzeugen eines angeregten Anregungsgases modulartig aufgebaut und über der Substratoberfläche so aneinandergefügt sind, **daß** sie ein Raster (31, 41) oder eine Reihe (11, 21, 71, 81a, b, c) bilden, und der Beschichtungsbereich an die Gestalt und Größe der Substratoberfläche angepaßt ist und
**daß** die Reihe bzw. das Raster aus Plasmaquellen (81b, 81c) zur Verminderung von Randeffekten unter einem Winkel α < 90° zur Richtung der Relativbewegung zwischen Substrat (83b, 83c) und Plasmaquellenanordnung (81b, 81c) angeordnet ist.

11. Vorrichtung nach Anspruch 10
**dadurch gekennzeichnet,**
**daß** der Winkel α 45 ° beträgt.

12. Vorrichtung nach einem der Ansprüche 10 oder 11,
**dadurch gekennzeichnet,**
**daß** sie Mittel zum Bewegen des Substrats (13, 23, 83 a-c) relativ zur Plasmaquellenanordnung (11, 21, 81 a-c) aufweist.

13. Vorrichtung nach wenigstens einem der Ansprüche 10 bis 12,
**dadurch gekennzeichnet,**
**daß** sie Mittel zur Erzeugung und Einleitung von Mikrowellen in die Plasmaquellen bzw. Module aufweist.

14. Vorrichtung nach Anspruch 13,
**dadurch gekennzeichnet,**
**daß** die Plasmaquellen bzw. die Module Mikrowellenhohlleiter (60), Mikrowellenresonatoren, das Anregungsgas führende Rohre in Mikrowellenleitem oder Mikrowellenresonatoren und/oder koaxiale Mikrowellenleiter, deren Innenleiter durch das Plasma des angeregten Anregungsgases gebildet wird, sind.

15. Vorrichtung nach Anspruch 14,
**dadurch gekennzeichnet,**
**daß** die Wände zwischen benachbarten Modulen gasdurchlässig, aber mikrowellenundurchlässig sind.

16. Vorrichtung nach einem der Ansprüche 10 bis 15,
**dadurch gekennzeichnet,**
**daß** der Abstand zwischen dem Substrat und der Plasmaquellenanordnung bzw. Module so groß gewählt ist, daß Randeffekte durch Diffusion der aus den Modulen austretenden Gase ausgeglichen werden.

## Claims

1. Remote plasma CVD process for coating or treating large-area substrates,
in which the reaction gas is excited by means of an excitation gas which is excited by means of a plasma remotely from the substrate surface which is to be coated, and
the excitation gas is excited in a plurality of plasma sources arranged above the substrate and, from there, is fed to the substrate together with the reaction gas,
**characterized**
**in that** the plasma sources are designed as modules and
the coating area is matched to the size and design of the substrate surface by joining together identical modules in a grid or a row,
and **in that** the substrate and the plasma source arrangement are moved relative to one another in such a way that the angle between the direction of movement and the axis of the plasma source arrangement is α < 90°.

2. Process according to Claim 1, **characterized in that** the substrate is moved relative to the plasma source arrangement during the coating or treatment.

3. Process according to Claim 2, **characterized in that**, to reduce boundary effects, the substrate and the plasma source arrangement are moved relative to one another in such a way that each location on the substrate passes through join areas between adjacent modules and module areas to the same extent.

4. Process according to Claim 3, **characterized in that** α = 45°.

5. Process according to at least one of Claims 1 to 4, **characterized in that** the substrate is passed through beneath the plasma source arrangement.

6. Process according to at least one of Claims 1 to 5, **characterized in that** the plasma is excited by means of microwaves.

7. Process according to Claim 6, **characterized in that** the microwave energy which is introduced into each module is selected to be so great that the boundary effects caused by joins between adjacent modules are minimized.

8. Process according to at least one of Claims 1 to 7, **characterized in that** a pulsed remote plasma CVD process (remote PICVD process) is used.

9. Plasma-enhanced chemical deposition process (CVD) for coating or treating large-area substrates,
in which a plurality of plasma electrodes, which are arranged in a grid, can be switched and controlled independently of one another and generate a large-area plasma zone above and in direct contact with the substrate surface which is to be coated, are arranged opposite the substrate surface which is to be coated,
**characterized**
**in that**, to reduce boundary effects, the substrate and the plasma electrode arrangement are moved relative to one another in such a way that each point on the substrate passes through the plasma column areas, which are in each case produced by the plasma electrodes, and overlapping areas of these plasma columns to the same extent.

10. Device for coating or treating large-area substrates by means of a remote plasma CVD process, having
a reaction chamber holding the substrate which is to be coated,
means for feeding a reaction gas into the reaction chamber,
a plurality of means for generating an excited excitation gas by means of a plasma, which are arranged above the substrate surface,
means for feeding the excited excitation gas into the reaction chamber together with the reaction gas and the substrate which is to be coated, and
means for discharging used gases,
**characterized**
**in that** the means for generating an excited excitation gas are of modular structure and are joined together above the substrate surface in such a way that they form a grid (31, 41) or a row (11, 21, 71, 81a, b, c), and the coating area is matched to the design and size of the substrate surface, and
**in that**, to reduce boundary effects, the row or grid of plasma sources (81b, 81c) is arranged at an angle α < 90° with respect to the direction of the relative movement between substrate (83b, 83c) and plasma source arrangement (81b, 81c).

11. Device according to Claim 10, **characterized in that** the angle α is 45°.

12. Device according to one of Claims 10 or 11,
**characterized in that** it includes means for moving the substrate (13, 23, 83 a-c) relative to the plasma source arrangement (11, 21, 81 a-c).

13. Device according to at least one of Claims 10 to 12, **characterized in that** it includes facilities for generating and introducing microwaves into the plasma sources or modules.

14. Device according to Claim 13, **characterized in that** the plasma sources or the modules are microwave waveguides (60), microwave resonators, tubes which guide the excitation gas in microwave conductors or microwave resonators and/or coaxial microwave conductors, the internal conductors of which are formed by the plasma of the excited excitation gas.

15. Device according to Claim 14, **characterized in that** the walls between adjacent modules are gas-permeable but microwave-impermeable.

16. Device according to one of Claims 10 to 15,
**characterized in that** the distance between the substrate and the plasma source arrangement or modules is selected to be sufficiently great for boundary effects to be compensated for by diffusion of the gases emerging from the modules.

## Revendications

1. Procédé de CVD assisté par plasma éloigné en vue du revêtement ou du traitement de substrats de grande surface, dans lequel l'excitation du gaz de réaction est effectuée par un gaz d'excitation excité au moyen d'un plasma, à distance de la surface du substrat à revêtir, et dans lequel le gaz d'excitation est excité dans plusieurs sources de plasma disposées au-dessus du substrat et est envoyé de celles-ci sur le substrat avec le gaz de réaction, **caractérisé en ce que** les sources de plasma se présentent sous la forme de modules et la zone de revêtement est adaptée à la grandeur et à la configuration de la surface du substrat en réunissant des modules identiques suivant une grille ou selon le cas une rangée, et **en ce que** le substrat et l'ensemble des sources de plasma sont déplacés l'un par rapport à l'autre de telle manière que l'angle entre la direction de déplacement et l'axe de l'ensemble des sources de plasma vaut α < 90°.

2. Procédé suivant la revendication 1,
**caractérisé en ce que** le substrat est déplacé par rapport à l'ensemble des sources de plasma pendant le revêtement ou le traitement.

3. Procédé suivant la revendication 2,
**caractérisé en ce que** le substrat et l'ensemble des sources de plasma sont déplacés les uns par rapport aux autres, en vue de réduire les effets de bord, de telle manière que chaque point du substrat traverse de façon identique des zones de jonction entre des modules adjacents et des zones modulaires adjacentes.

4. Procédé suivant la revendication 3,
**caractérisé en ce que** α = 45°.

5. Procédé suivant au moins une des revendications 1 à 4, **caractérisé en ce que** le substrat est conduit en dessous de l'ensemble des sources de plasma.

6. Procédé suivant au moins une des revendications 1 à 5, **caractérisé en ce que** le plasma est excité au moyen de micro-ondes.

7. Procédé suivant la revendication 6,
**caractérisé en ce que** le niveau de l'énergie des micro-ondes introduite dans chaque module est choisi de telle sorte que les effets de bord provoqués par des zones de jonction entre des modules adjacents soient minimisés.

8. Procédé suivant au moins une des revendications 1 à 7, **caractérisé en ce que** l'on utilise un procédé de CVD assisté par plasma éloigné pulsé (procédé de PICVD éloigné).

9. Procédé de dépôt chimique assisté par plasma (CVD) en vue du revêtement ou du traitement de substrats de grande surface, dans lequel plusieurs électrodes de plasma, disposées en une grille pouvant être enclenchées et commandées indépendamment les unes des autres, qui produisent une zone de plasma de grande surface au-dessus de la surface du substrat à revêtir et en contact direct avec celle-ci sont disposées en face de la surface du substrat à revêtir, **caractérisé en ce que** le substrat et l'ensemble des électrodes de plasma sont déplacés l'un par rapport à l'autre, en vue de réduire les effets de bord, de telle manière que chaque point du substrat traverse de façon identique les zones de colonnes de plasma produites par les électrodes de plasma et les zones de recouvrement de ces colonnes de plasma.

10. Dispositif pour le revêtement ou le traitement de substrats de grande surface au moyen d'un procédé de CVD assisté par plasma éloigné, avec une chambre de réaction avec le substrat à revêtir, des dispositifs pour introduire un gaz de réaction dans la chambre de réaction, plusieurs dispositifs pour produire un gaz d'excitation excité au moyen d'un plasma, qui sont disposés au-dessus de la surface du substrat, des dispositifs pour introduire le gaz d'excitation excité dans la chambre de réaction avec le gaz de réaction et le substrat à revêtir ainsi que des dispositifs pour évacuer les gaz consommés, **caractérisé en ce que** les dispositifs pour produire un gaz d'excitation excité ont une structure modulaire et sont réunis au-dessus de la surface du substrat de façon à former une grille (31, 41) ou une rangée (11, 21, 71, 81a, b, c), et la zone de revêtement est adaptée à la configuration et à la grandeur de la surface du substrat, et **en ce que** la rangée ou selon le cas la grille composée de sources de plasma (81b, 81c) est disposée, en vue de réduire les effets de bord, sous un angle α < 90° par rapport à la direction du mouvement relatif entre le substrat (83b, 83c) et l'ensemble des sources de plasma (81b, 81c).

11. Dispositif suivant la revendication 10,
**caractérisé en ce que** l'angle α = 45°.

12. Dispositif suivant l'une des revendications 10 ou 11, **caractérisé en ce qu'**il présente des moyens pour déplacer le substrat (13, 23, 83 a-c) par rapport à l'ensemble des sources de plasma (11, 21, 81 a-c).

13. Dispositif suivant au moins une des revendications 10 à 12, **caractérisé en ce qu'**il présente des moyens pour produire et introduire des micro-ondes dans les sources de plasma, respectivement dans les modules.

14. Dispositif suivant la revendication 13,
**caractérisé en ce que** les sources de plasma, respectivement les modules, sont des conducteurs creux pour micro-ondes (60), des résonateurs pour micro-ondes, des tubes conduisant le gaz d'excitation dans des conducteurs pour micro-ondes ou des résonateurs pour micro-ondes et/ou des conducteurs coaxiaux pour micro-ondes, dont le conducteur intérieur est formé par le plasma du gaz d'excitation excité.

15. Dispositif suivant la revendication 14,
**caractérisé en ce que** les parois entre des modules adjacents sont perméables au gaz, mais imperméables aux micro-ondes.

16. Dispositif suivant l'une quelconque des revendications 10 à 15, **caractérisé en ce que** la valeur de la distance entre le substrat et l'ensemble des sources de plasma, respectivement les modules, est choisie de façon à compenser les effets de bord par diffusion des gaz sortant des modules.
